(19) Europäisches Patentamt / European Patent Office / Office européen des brevets

(11) **EP 4 456 147 A1**

(12) **EUROPEAN PATENT APPLICATION**
published in accordance with Art. 153(4) EPC

(43) Date of publication:
**30.10.2024 Bulletin 2024/44**

(21) Application number: **22911146.3**

(22) Date of filing: **17.12.2022**

(51) International Patent Classification (IPC):
*H01L 29/872* $^{(2006.01)}$    *H01L 21/329* $^{(2006.01)}$
*H01L 29/47* $^{(2006.01)}$    *H01L 29/861* $^{(2006.01)}$
*H01L 29/868* $^{(2006.01)}$

(52) Cooperative Patent Classification (CPC):
**H01L 29/47; H01L 29/66083; H01L 29/861;
H01L 29/868; H01L 29/872**

(86) International application number:
**PCT/JP2022/046558**

(87) International publication number:
**WO 2023/120443 (29.06.2023 Gazette 2023/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.12.2021 JP 2021210457**

(71) Applicants:
• **Tamura Corporation
Tokyo 178-8511 (JP)**

• **Novel Crystal Technology, Inc.
Sayama-shi, Saitama 350-1328 (JP)**

(72) Inventor: **TAKATSUKA, Akio
Sayama-shi, Saitama 350-1328 (JP)**

(74) Representative: **Betten & Resch
Patent- und Rechtsanwälte PartGmbB
Maximiliansplatz 14
80333 München (DE)**

(54) **JUNCTION BARRIER SCHOTTKY DIODE AND METHOD FOR MANUFACTURING SAME**

(57)    Provided are a junction barrier Schottky diode having a trench structure that has high surge resistance and reduced energy loss during switching operation, and a method for manufacturing the same. An embodiment provides a junction barrier Schottky diode 1 comprising: an n-type semiconductor layer 11 having a plurality of trenches 111; a p-type semiconductor film 12 provided in contact with an inner surface of the a plurality of trenches 111; an anode electrode 13 which is provided on a first surface 113 of the n-type semiconductor layer 11 and in contact with a mesa-shaped portion 112 of the n-type semiconductor layer 11, a part of the anode electrode 13 being covered by the p-type semiconductor film 12 in the plurality of trenches 111; and a cathode electrode 14 provided on a second surface 114 of the n-type semiconductor layer 11 directly or with another layer therebetween.

*FIG. 1*

# Description

Technical Field

The present invention relates to a junction barrier Schottky diode and a method for manufacturing the same.

Background Art

A trench junction barrier Schottky (JBS) diode is known which includes an n-type semiconductor layer formed on an n-type semiconductor substrate and having trenches opening on a surface opposite to the n-type semiconductor substrate, p-type semiconductor layers buried in the trenches of the n-type semiconductor layer, an anode electrode formed on the n-type semiconductor layer so as to be in contact with the p-type semiconductor layers, and a cathode electrode formed on a surface of the n-type semiconductor substrate opposite to the n-type semiconductor layer (see Patent Literature 1).

In the trench JBS diode described in Patent Literature 1, when reverse voltage is applied between the anode electrode and the cathode electrode, the current does not flow due to the Schottky barrier, and at this time, depletion layers spread from the p-type semiconductor layers and close channels between adjacent p-type semiconductor layers, hence, leakage current is effectively suppressed.

Citation List

Patent Literatures

Patent Literature 1: JP 2019/36593 A

Summary of Invention

In the trench JBS diode described in Patent Literature 1, however, the electrical resistance of the p-type semiconductor layers is large because the p-type semiconductor layers are buried in the entire region in the trenches. Therefore, heat generated when a surge current occurs is large, and the connecting portions around the p-type semiconductor layers may be likely to be damaged. In other words, it may cause low surge resistance. In addition, if the electrical resistance of the p-type semiconductor layer is high, it hinders the movement of charge necessary for charging/discharging for formation/disappearance of the depletion region near the pn junction, resulting in that energy losses during switching operations become large in some cases.

It is an object of the invention to provide a junction barrier Schottky diode with a trench structure that is excellent in surge resistance and exhibits suppressed energy losses during switching operations, and a method for manufacturing the same.

To achieve the above-mentioned object, an aspect of the present invention provides a junction barrier Schottky diode defined in (1) to (4) below and a method for manufacturing a junction barrier Schottky diode defined in (5) below.

(1) A junction barrier Schottky diode, comprising:

an n-type semiconductor layer comprising an n-type semiconductor and having a plurality of trenches that open on a first surface;
a p-type semiconductor film comprising a p-type semiconductor and provided in contact with inner surfaces of the plurality of trenches;
an anode electrode that is provided on the first surface of the n-type semiconductor layer so as to be in contact with a mesa-shaped portion between the plurality of trenches of the n-type semiconductor layer and comprises a portion covered with the p-type semiconductor film in the plurality of trenches; and
a cathode electrode provided, directly or through another layer, on a second surface of the n-type semiconductor layer opposite to the first surface,
wherein electron affinity $\chi_p$ and work function $\varphi_p$ of the p-type semiconductor and electron affinity $\chi_n$ and work function $\varphi_n$ of the n-type semiconductor satisfy a condition represented by an expression of the form $\chi_n - \chi_p > \varphi_p - \varphi_n$.

(2) The junction barrier Schottky diode defined in (1), wherein the n-type semiconductor layer and the p-type semiconductor film comprise different semiconductors.

(3) The junction barrier Schottky diode defined in (2), wherein the n-type semiconductor layer comprises a gallium oxide-based semiconductor.

(4) The junction barrier Schottky diode defined in any one of (1) to (3), wherein the p-type semiconductor includes $Cu_2O$, $NiO$, $Ag_2O$, polycrystalline Si, single crystal Si, amorphous Si, $SnO$, or $CuO$.

(5) A method for manufacturing a junction barrier Schottky diode, comprising:

forming a plurality of trenches on a first surface of an n-type semiconductor layer that comprises an n-type semiconductor;
forming a p-type semiconductor film that comprises a p-type semiconductor and is in contact with inner surfaces of the plurality of trenches;
forming, on the first surface of the n-type semiconductor layer, an anode electrode that comprises a portion covered with the p-type semiconductor film in the plurality of trenches; and
forming a cathode electrode, directly or through another layer, on a second surface of the n-type semiconductor layer opposite to the first surface,

wherein electron affinity $\chi_p$ and work function $\varphi_p$ of the p-type semiconductor and electron affinity $\chi_n$ and work function $\varphi_n$ of the n-type semiconductor satisfy a condition represented by an expression of the form $\chi_n - \chi_p > \varphi_p - \varphi_n$.

Advantageous Effects of Invention

According to the invention, it is possible to provide a junction barrier Schottky diode with a trench structure that is excellent in surge resistance and exhibits suppressed energy losses during switching operations, and a method for manufacturing the same.

Brief Description of Drawings

FIG. 1 is a vertical cross-sectional view showing a junction barrier Schottky (JBS) diode in an embodiment of the present invention.

FIG. 2A is a vertical cross-sectional view showing a modification of a p-type semiconductor film of the JBS diode.

FIG. 2B is a vertical cross-sectional view showing a modification of the p-type semiconductor film of the JBS diode.

FIG. 3A is a vertical cross-sectional view showing another modification of the p-type semiconductor film of the JBS diode.

FIG. 3B is a vertical cross-sectional view showing another modification of the p-type semiconductor film of the JBS diode.

FIG. 4A is an explanatory vertical cross-sectional view showing a process of manufacturing the JBS diode in the embodiment.

FIG. 4B is an explanatory vertical cross-sectional view showing the process of manufacturing the JBS diode in the embodiment.

FIG. 4C is an explanatory vertical cross-sectional view showing the process of manufacturing the JBS diode in the embodiment.

FIG. 5A is an explanatory vertical cross-sectional view showing the process of manufacturing the JBS diode in the embodiment.

FIG. 5B is an explanatory vertical cross-sectional view showing the process of manufacturing the JBS diode in the embodiment.

FIG. 5C is an explanatory vertical cross-sectional view showing the process of manufacturing the JBS diode in the embodiment.

FIG. 6A is an explanatory vertical cross-sectional view showing the process of manufacturing the JBS diode in the embodiment.

FIG. 6B is an explanatory vertical cross-sectional view showing the process of manufacturing the JBS diode in the embodiment.

Description of Embodiments

(Embodiment)

(Configuration of a JBS diode)

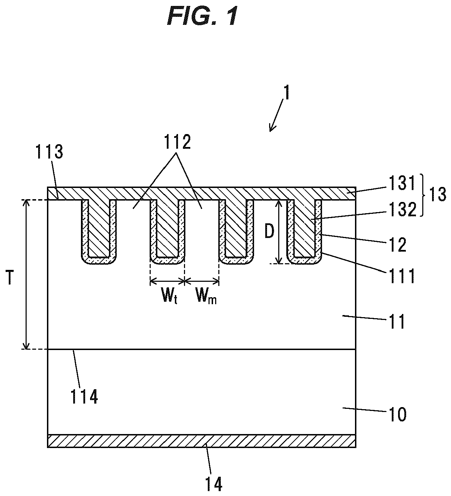

FIG. 1 is a vertical cross-sectional view showing a junction barrier Schottky (JBS) diode 1 in an embodiment of the invention. The JBS diode 1 is a vertical JBS diode that has a trench structure.

The JBS diode 1 includes an n-type semiconductor layer 11 having plural trenches 111 that open on a first surface 113, p-type semiconductor films 12 provided in contact with inner surfaces of the trenches 111 of the n-type semiconductor layer 11, an anode electrode 13 that is provided on the first surface 113 of the n-type semiconductor layer 11 so as to be in contact with mesa-shaped portions 112 between the plural trenches 111 of the n-type semiconductor layer 11 and has a portion 132 covered with the p-type semiconductor films 12 in the plural trenches 111, and a cathode electrode 14 provided, directly or through another layer, on a second surface 114 of the n-type semiconductor layer 11 opposite to the first surface 113.

Typically, the JBS diode 1 includes an n-type semiconductor substrate 10 as a base for epitaxial growth of the n-type semiconductor layer 11, and the second surface 114 of the n-type semiconductor layer 11 is in contact with the n-type semiconductor substrate 10, as shown in FIG. 1. In this case, the cathode electrode 14 is provided on a surface of the n-type semiconductor substrate 10 opposite to the n-type semiconductor layer 11. In other words, the cathode electrode 14 is provided on the second surface 114 of the n-type semiconductor layer 11 through the n-type semiconductor substrate 10.

The n-type semiconductor layer 11 and the anode electrode 13 form a Schottky junction, and the JBS diode 1 uses the rectifying properties of this Schottky junction. In the JBS diode 1, a potential barrier at an interface between the anode electrode 13 and the n-type semiconductor layer 11 as viewed from the n-type semiconductor layer 11 is lowered by applying forward voltage between the anode electrode 13 and the cathode electrode 14 (positive potential on the anode electrode 13 side), allowing a current to flow from the anode electrode 13 to the cathode electrode 14.

On the other hand, when reverse voltage is applied between the anode electrode 13 and the cathode electrode 14 (negative potential on the anode electrode 13 side), the current does not flow due to the Schottky barrier. At this time, since depletion layers spread from the p-type semiconductor films 12 inside the trenches 111 and close channels in the mesa-shaped portions 112 between adjacent trenches 111, leakage current is effectively suppressed.

The JBS diode 1 in the present embodiment has a trench JBS structure and thus can have a high withstand voltage without an increase in resistance of the n-type semiconductor layer 11. In other words, the JBS diode 1 is a Schottky barrier diode having a high withstand voltage and low loss.

The n-type semiconductor substrate 10 is formed of a single crystal of an n-type gallium oxide-based semiconductor containing a group IV element such as Si or Sn as a donor. A donor concentration in the n-type semiconductor substrate 10 is, e.g., not less than $1.0 \times 10^{16}$ cm$^{-3}$ and not more than $1.0 \times 10^{22}$ cm$^{-3}$, preferably not less than $1.0 \times 10^{18}$ cm$^{-3}$ and not more than $1.0 \times 10^{22}$ cm$^{-3}$. A thickness of the n-type semiconductor substrate 10 is, e.g., not less than 5 $\mu$m and not more than 650 $\mu$m.

The gallium oxide-based semiconductor here is $Ga_2O_3$ or is $Ga_2O_3$ doped with one or both of Al and In, and has a composition represented by $(Ga_xAl_yIn_{(1-x-y)})_2O_3$ ($0<x\leq1, 0\leq y<1, 0<x+y\leq1$). $Ga_2O_3$ has a wider band gap when doped with Al and a narrower band gap when doped with In. The single crystal of the gallium oxide-based semiconductor mentioned above typically has a β-crystal structure. For example, $Ga_2O_3$, which is a typical example of gallium oxide-based semiconductor, has a band gap energy of 4.5 to 4.9 eV and a breakdown field strength of about 8.0 MV/cm.

The n-type semiconductor layer 11 is formed of a single crystal of an n-type gallium oxide-based semiconductor containing a group IV element such as Si or Sn as a donor. A donor concentration in the n-type semiconductor layer 11 is lower than the donor concentration in the n-type semiconductor substrate 10. The n-type semiconductor layer 11 is, e.g., an epitaxial film epitaxially grown on the n-type semiconductor substrate 10.

A high-donor-concentration layer containing a high concentration of donor may be formed between the n-type semiconductor substrate 10 and the n-type semiconductor layer 11. The high-donor-concentration layer is used in case where, e.g., the n-type semiconductor layer 11 is epitaxially grown on the n-type semiconductor substrate 10. At the early growth stage of the n-type semiconductor layer 11, the amount of dopant incorporated thereinto is unstable and an acceptor impurity is diffused from the n-type semiconductor substrate 10. Thus, resistance may increase in a region of the n-type semiconductor layer 11 close to the interface with the n-type semiconductor substrate 10 when the n-type semiconductor layer 11 is grown directly on the n-type semiconductor substrate 10. The high-donor-concentration layer is used to avoid such problems. A donor concentration in the high-donor-concentration layer is set to, e.g., higher than the donor concentration in the n-type semiconductor layer 11, and is more preferably set to not less than 10 times higher than the donor concentration in the n-type semiconductor layer 11.

As the donor concentration in the n-type semiconductor layer 11 increases, electrical field strength in each part of the JBS diode 1 increases. The donor concentration in the n-type semiconductor layer 11 is, e.g., not less than $2 \times 10^{14}$ cm$^{-3}$ and not more than $4 \times 10^{17}$ cm$^{-3}$. In order for the JBS diode 1 to have a withstand voltage of not less than 400 V, the donor concentration in the n-type semiconductor layer 11 is preferably not more than $4 \times 10^{17}$ cm$^{-3}$, and more preferably, not less than $8 \times 10^{15}$ cm$^{-3}$ and not more than $4 \times 10^{17}$ cm$^{-3}$.

In addition, in order for the JBS diode 1 to have a withstand voltage of not less than 600 V, not more than $2 \times 10^{17}$ cm$^{-3}$ is preferable, and not less than $4 \times 10^{15}$ cm$^{-3}$ and not more than $2 \times 10^{17}$ cm$^{-3}$ is more preferable. In order for the JBS diode 1 to have a withstand voltage of not less than 1200 V, the donor concentration in the n-type semiconductor layer 11 is preferably not more than $1 \times 10^{17}$ cm$^{-3}$, and more preferably, not less than $2 \times 10^{15}$ cm$^{-3}$ and not more than $1 \times 10^{17}$ cm$^{-3}$.

In order for the JBS diode 1 to have a withstand voltage of not less than 2200 V, the donor concentration in the n-type semiconductor layer 11 is preferably not more than $8 \times 10^{16}$ cm$^{-3}$, and more preferably, not less than $1.6 \times 10^{15}$ cm$^{-3}$ and not more than $8 \times 10^{16}$ cm$^{-3}$. In order for the JBS diode 1 to have a withstand voltage of not less than 3300 V, the donor concentration in the n-type semiconductor layer 11 is preferably not more than $5 \times 10^{16}$ cm$^{-3}$, and more preferably, not less than $1 \times 10^{15}$ cm$^{-3}$ and not more than $5 \times 10^{16}$ cm$^{-3}$.

In order for the JBS diode 1 to have a withstand voltage of not less than 5000 V, the donor concentration in the n-type semiconductor layer 11 is preferably not more than $3 \times 10^{16}$ cm$^{-3}$, and more preferably, not less than $6 \times 10^{14}$ cm$^{-3}$ and not more than $3 \times 10^{16}$ cm$^{-3}$. In order for the JBS diode 1 to have a withstand voltage of not less than 10000 V, the donor concentration in the n-type semiconductor layer 11 is preferably not more than $1 \times 10^{16}$ cm$^{-3}$, and more preferably, not less than $2 \times 10^{14}$ cm$^{-3}$ and not more than $1 \times 10^{16}$ cm$^{-3}$.

When a thickness T of the n-type semiconductor layer 11 is designed so that an electric field generated in each part when applying a reverse voltage equal to the design withstand voltage to the JBS diode 1 is smaller than the breakdown field, the larger the depth D of the trench 111, the lower the electric field at the Schottky interface between the anode electrode 13 and the first surface 113 when reverse voltage is applied. On the other hand, if the depth D of the trench 111 is too large, electrical resistance between the anode electrode 13 and the cathode electrode 14 of the JBS diode 1 increases. Thus, the depth D of the trench 111 is preferably not less than

0.5 μm and not more than 5 μm.

The thickness T of the n-type semiconductor layer 11 has, e.g., a value obtained by adding 0.5 to 110 μm to the depth D of the trench 111 measured from the first surface 113. And in order for the JBS diode 1 to have a withstand voltage of not less than 400 V, the thickness T of the n-type semiconductor layer 11 preferably has a value obtained by adding 0.6 to 9 μm to the depth D of the trench 111, more preferably has a value obtained by adding 0.6 to 6 μm.

Furthermore, in order for the JBS diode 1 to have a withstand voltage of not less than 600 V, the thickness T of the n-type semiconductor layer 11 preferably has a value obtained by adding 0.8 to 11 μm to the depth D of the trench 111, more preferably has a value obtained by adding 0.8 to 7 μm. In order for the JBS diode 1 to have a withstand voltage of not less than 1200 V, the thickness T of the n-type semiconductor layer 11 preferably has a value obtained by adding 1.5 to 20 μm to the depth D of the trench 111, more preferably has a value obtained by adding 1.5 to 12 μm.

In order for the JBS diode 1 to have a withstand voltage of not less than 2200 V, the thickness T of the n-type semiconductor layer 11 preferably has a value obtained by adding 4 to 40 μm to the depth D of the trench 111, more preferably has a value obtained by adding 4 to 25 μm. In order for the JBS diode 1 to have a withstand voltage of not less than 3300 V, the thickness T of the n-type semiconductor layer 11 preferably has a value obtained by adding 5 to 50 μm to the depth D of the trench 111, more preferably has a value obtained by adding 5 to 30 μm.

In order for the JBS diode 1 to have a withstand voltage of not less than 5000 V, the thickness T of the n-type semiconductor layer 11 preferably has a value obtained by adding 7 to 90 μm to the depth D of the trench 111, more preferably has a value obtained by adding 7 to 55 μm. In order for the JBS diode 1 to have a withstand voltage of not less than 10000 V, the thickness T of the n-type semiconductor layer 11 preferably has a value obtained by adding 12 to 180 μm to the depth D of the trench 111, more preferably has a value obtained by adding 12 to 110 μm.

When a width Wt of the trench 11 is narrower, the conduction loss can be more reduced but it is more difficult to manufacture, causing a decrease in production yield. Therefore, not less than 0.3 μm and not more than 5 μm is preferable.

As a width $W_m$ of the mesa-shaped portion 112 between adjacent trenches 111 of the n-type semiconductor layer 11 decreases, the electric field strength directly below the anode electrode 13 in the mesa-shaped portion 112 and the electric field strength at the junction between the n-type semiconductor layer 11 and the p-type semiconductor film 12 decrease. To effectively reduce these electric field strengths, the width $W_m$ of the mesa-shaped section 112 is preferably not more than 5 μm. On the other hand, the smaller the width $W_m$ of the

mesa-shaped portion 112, the more difficult it is to manufacture the trench 111, hence, the width $W_m$ of the mesa-shaped portion 112 is preferably not less than 0.25 μm.

The anode electrode 13 includes a portion 131 located outside the trenches 111 and the portion 132 located inside the trenches 111. The anode electrode 13 is configured such that a portion in contact with the n-type semiconductor layer 11 is formed of a material that forms a Schottky junction with the n-type semiconductor layer 11. That is, the anode electrode 13 when having a single layer structure is entirely formed of a material that forms a Schottky junction with the n-type semiconductor layer 11, and the anode electrode 13 when having a multilayer structure is configured such that at least a layer in contact with the n-type semiconductor layer 11 is formed of a material that forms a Schottky junction with the n-type semiconductor layer 11.

As the material of the portion of the anode electrode 13 that is in contact with the n-type semiconductor layer 11, it is possible to use, e.g., Pt, Ni, Au, Cu, Mo, W, Fe, Pd, or Cr, which forms a Schottky junction with the n-type semiconductor layer 11 formed of a gallium oxide-based semiconductor.

In case that, e.g., the n-type semiconductor layer 11 is formed of $Ga_2O_3$, the turn-on voltage of the JBS diode 1 is not less than 0.7 and not more than 1.2 V when using Pt or Ni as the material of the anode electrode 13, and the turn-on voltage of the JBS diode 1 is not less than 0.3 and not more than 0.8 V when using Mo as the material of anode electrode 13.

In the JBS diode 1, a potential barrier is formed in the mesa-shaped portion 112. Therefore, the turn-on voltage depends on the width $W_m$ of the mesa-shaped portion 112 and increases as the width $W_m$ decreases.

The field strength in the JBS diode 1 is affected by the width $W_m$ of the mesa portion 112 between two adjacent trenches 111 and the depth D of the trench 111, etc., as described above but is hardly affected by the planar pattern of the trenches 111. Thus, the planar pattern of the trenches 111 on the n-type semiconductor layer 11 is not specifically limited. The plural trenches 111 may be included in one continuous trench as long as the planar pattern of the trenches 111 is a planar pattern that forms the mesa-shaped portions 112 (e.g., a mesh pattern).

When the JBS diode 1 includes the n-type semiconductor substrate 10, the cathode electrode 14 is in ohmic contact with the n-type semiconductor substrate 10. The cathode electrode 14 is formed of a metal such as Ti. The cathode electrode 14 may have a multilayer structure formed by stacking different metal films, e.g., Ti/Au, Ti/Al, Ti/Ni/Au, or Ti/Al/Ni/Au. For reliable ohmic contact between the cathode electrode 14 and the n-type semiconductor substrate 10, the cathode electrode 14 is preferably configured such that a layer in contact with the n-type semiconductor substrate 10 is formed of Ti. When the JBS diode 1 does not include the n-type semiconductor substrate 10 and the cathode electrode 14 is directly connected to the n-type semiconductor layer 11, the cathode electrode 14 is in ohmic contact with the n-type semiconductor layer 11.

The p-type semiconductor film 12 is used to improve the surge resistance of the JBS diode 1. The p-type semiconductor film 12 is a deposited film formed by deposition using a sputtering method or a CVD method, etc., and is not a region which is formed as part of the n-type semiconductor layer 11 by implanting an impurity into the inner surfaces of the trenches 111 using an ion implantation method.

Normally, pn diodes have a higher on-voltage (forward turn-on voltage) than Schottky diodes. Therefore, it is possible to design so that a pn diode portion (a pn junction portion between the p-type semiconductor film 12 and the n-type semiconductor layer 11) does not turn on at the voltage at which the JBS diode 1 turns on. It is possible to design such that, e.g., the on-voltage of the JBS diode 1 is about 1 V and the on-voltage of the pn diode portion is about 2 V

This allows for high-speed operation inherent to Schottky diode since the pn diode portion does not turn on during normal operation of the JBS diode 1. On the other hand, when an inrush current occurs, the voltage of the JBS diode 1 rises and reaches the voltage at which the pn diode portion turns on, and current is injected from the p-type semiconductor film 12 to the n-type semiconductor layer 11.

At that time, resistance of a drift layer decreases and a large current called inrush current flows through JBS diode 1 but the voltage rise is suppressed, hence, temperature rise is suppressed and damage to the JBS diode 1 due to inrush current can be prevented.

The p-type semiconductor film 12 is in the form of a film and thus has lower electrical resistance than a p-type semiconductor layer buried in the entire region in the trenches, such as the p-type semiconductor layer included in the trench JBS diode described in Patent Literature 1 mentioned above. Therefore, heat generated when a surge current occurs is small, and damage to the connecting portions around the p-type semiconductor film can be suppressed. In addition, since the electrical resistance of the p-type semiconductor film 12 is small, energy losses during switching operations of the JBS diode 1 can be suppressed.

The p-type semiconductor film 12 is formed of a material that satisfies the condition represented by Expression 1 below so that a potential barrier is formed between itself and the n-type semiconductor layer 11. In Expression 1, $\chi_p$ and $\varphi_p$ are respectively electron affinity and work function of the p-type semiconductor which is the material of the p-type semiconductor film 12, and $\chi_n$ and $\varphi_n$ are respectively electron affinity and work function of the n-type semiconductor which is the material of the n-type semiconductor layer 11. The work function mentioned above is the energy of the Fermi level as seen from the vacuum level. For example, $\chi_n$ of $Ga_2O_3$, which is a typical material of the n-type semiconductor layer 11, is about 4.0 eV, and $\varphi_n$ varies depending on a carrier concentration in the n-type semiconductor layer 11 but is about 4.3 to 4.0 eV in the carrier concentration range of $1 \times 10^{14}$ cm$^{-3}$ to $1 \times 10^{19}$ cm$^{-3}$.

$$\chi_n - \chi_p > \varphi_p - \varphi_n \ldots \text{(Expression 1)}$$

Materials which can be used as the material of the p-type semiconductor film 12 and can satisfy the condition represented by Expression 1 above are, e.g., p-type semiconductors such as $Cu_2O$, NiO, $Ag_2O$, polycrystalline Si, single crystal Si, amorphous Si, SnO, and CuO. Mixtures containing a p-type semiconductor such as $Cu_2O$, NiO, $Ag_2O$, polycrystalline Si, single crystal Si, amorphous Si, SnO, or CuO at a concentration sufficient to make the p-type semiconductor film 12 p-type can also be used as the material of the p-type semiconductor film 12.

That is, the p-type semiconductor as the material of the p-type semiconductor film 12 includes, e.g., $Cu_2O$, NiO, $Ag_2O$, polycrystalline Si, single crystal Si, amorphous Si, SnO, or CuO. $Cu_2O$, NiO and SnO exhibit p-type conductivity without adding a dopant but may contain an acceptor impurity such as Li or nitrogen (N). Polycrystalline Si, single crystal Si, and amorphous Si preferably contain an acceptor impurity such as B or Al.

A carrier concentration in the p-type semiconductor film 12 is preferably higher than the carrier concentration in the n-type semiconductor layer 11 so that the depletion layer generated in the p-type semiconductor film 12 from the interface with the n-type semiconductor layer 11 does not increase in thickness and reach the anode electrode 13 when reverse voltage is applied to the JBS diode 1.

A thickness d of the p-type semiconductor film 12 preferably satisfies the condition represented by Expression 2 below to obtain the desired withstand voltage of the JBS diode 1. In Expression 2, $V_{BR}$ is the desired withstand voltage (design withstand voltage), $N_D$ is the carrier concentration in the n-type semiconductor layer 11, $N_A$ is the carrier concentration in the p-type semiconductor film 12, $\varepsilon_n$ is the electric permittivity of the n-type semiconductor layer 11, and q is the elementary charge.

$$d \geq \sqrt{\frac{2\varepsilon_n N_D V_{BR}}{q N_A^2}} \ \ldots \text{(Expression 2)}$$

In case that, e.g., the carrier concentration in the n-type semiconductor layer 11 formed of a gallium oxide-based semiconductor is $1 \times 10^{16}$ cm$^{-3}$ and the carrier concentration in the p-type semiconductor film 12 is $1 \times 10^{19}$ cm$^{-3}$, the withstand voltage of the JBS diode 1 can be not less than 1200 V when the thickness of the p-type semiconductor film 12 is not less than 200 nm.

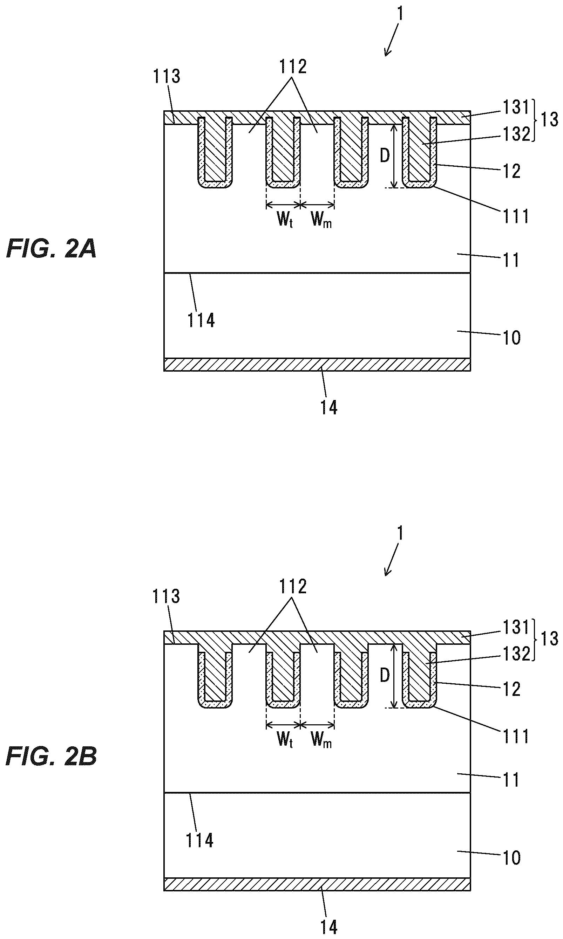

FIGS. 2A and 2B are vertical cross-sectional views showing modifications of the p-type semiconductor film of the JBS diode 1. In the JBS diode 1, the height of the upper end of the p-type semiconductor film 12 does not need to match the height of the first surface 113. That is, the upper end of the p-type semiconductor film 12 may be higher than the first surface 113 as shown in FIG. 2A, and the upper end of the p-type semiconductor film 12 may be lower than the first surface 113 as shown in FIG. 2B.

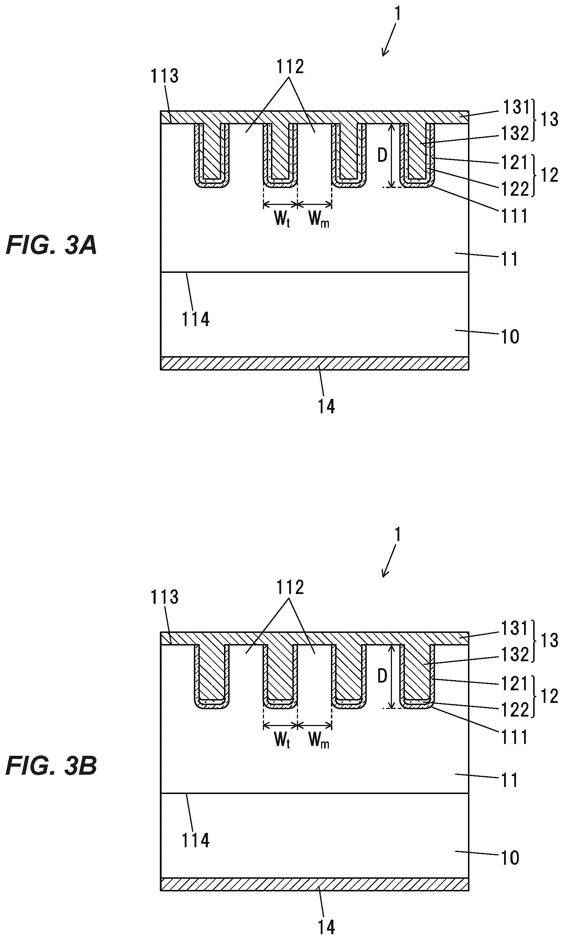

FIGS. 3A and 3B are vertical cross-sectional views showing other modifications of the p-type semiconductor film of the JBS diode 1. As shown in FIG. 3A, the p-type semiconductor film 12 may be composed of a p-type semiconductor film 121 in contact with the inner surface of the trench 111, and a p-type semiconductor film 122 stacked thereon on the inner side. An impurity concentration in the p-type semiconductor film 122 is higher than an impurity concentration in the p-type semiconductor film 121. A carrier concentration in the p-type semiconductor film 121 in the structure shown in FIG. 3A can be set lower than the carrier concentration limit determined by (Expression 2) above, hence, when reverse voltage is applied to the JBS diode 1, the electric field applied to trench corner portions of the p-type semiconductor film 121 and the n-type semiconductor layer 11 (the portions near the curved portions of the bottom edge of the trench 111) can be smaller than in the structure of FIG. 1.

Alternatively, the p-type semiconductor film 122 may have a shape which covers only around the bottom of the portion 132 of the anode electrode 13 inside the trench 111, as shown in FIG. 3B. Also in this case, the carrier concentration in the p-type semiconductor film 121 in the structure shown in FIG. 3B can be set lower than the carrier concentration limit determined by (Expression 2) above, hence, when reverse voltage is applied to the JBS diode 1, the electric field applied to the trench corner portions of the p-type semiconductor film 121 and the n-type semiconductor layer 11 can be smaller than in the structure of FIG. 1.

(Method for manufacturing the JBS diode)

An example of a method for manufacturing the JBS diode 1 will be described below.

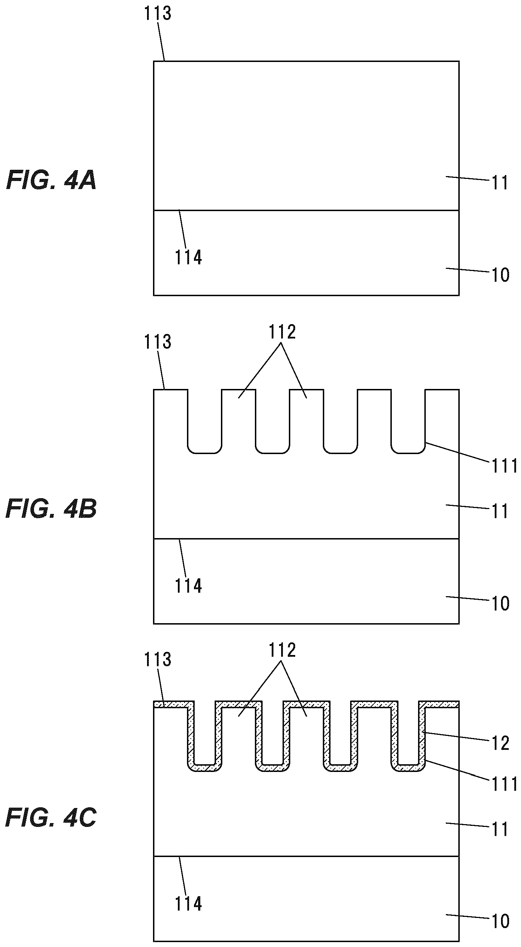

FIGS. 4A to 4C, 5A to 5C, 6A and 6B are explanatory vertical cross-sectional views showing a process of manufacturing the JBS diode 1 in the present embodiment. First, as shown in FIG. 4A, a single crystal of a gallium oxide-based semiconductor with a controlled donor concentration is epitaxially grown on the n-type semiconductor substrate 10 by a HVPE method, a CVD method, or an MBE method, etc., thereby forming an n-type semiconductor layer 11.

Next, as shown in FIG. 4B, plural trenches 111 are formed on the first surface 113 of the n-type semiconductor layer 11 by photolithography and dry etching, etc. The preferable conditions of the dry etching used to form the trenches 111 are, e.g., use of $BCl_3$ (30 sccm)

as an etching gas, pressure of 1.0 Pa, antenna power of 160W, bias power of 17W, and duration of 90 minutes.

Next, as shown in FIG. 4C, a p-type semiconductor is deposited on the entire surface of the n-type semiconductor layer 11 on the first surface 113 side by a sputtering method or a CVD method, etc., thereby forming the p-type semiconductor film 12. At this point, the p-type semiconductor film 12 covers the inner surfaces of the trenches 111 and the first surface 113.

When using, e.g., $Cu_2O$ as the material of the p-type semiconductor film 12, it is possible to use the method described in Non-Patent Literature "Appl. Phys. Lett. 111, 093501 (2017), Fabrication and characterization of sputtered $Cu_2O$:N/c-Si heterojunction diode". When using NiO as the material of the p-type semiconductor film 12, it is possible to use the method described in Non-Patent Literature "Appl. Phys. Lett. 117, 022104 (2020), A 1.86-kV double-layered NiO/$\beta$-$Ga_2O_3$-vertical pn heterojunction diode". Furthermore, when using polycrystalline Si, amorphous Si, or single crystal Si as the material of the p-type semiconductor film 12, it is possible to respectively use known deposition methods.

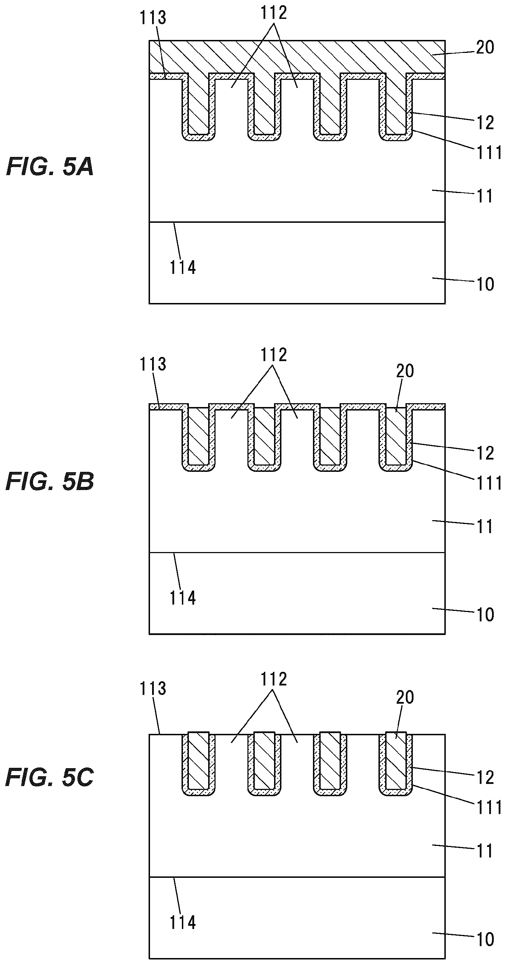

Next, as shown in FIG. 5A, a photoresist 20 is deposited on the entire surface of the p-type semiconductor film 12 by the spin coating method, etc., at least to the height where the voids in the trenched 111 are filled. At this time, deposition is performed so that the height difference between peaks and recesses on the surface of the photoresist 20 is smaller than the height difference between peaks and recesses on the p-type semiconductor film 12.

Next, as shown in FIG. 5B, the p-type semiconductor film 12 on the first surface 113 is exposed by etching back the photoresist 20. For etching of the photoresist 20, e.g., a plasma asher device using oxygen plasma, etc., is used.

Next, as shown in FIG. 5C, the first surface 113 of the n-type semiconductor layer 11 is exposed by etching the p-type semiconductor film 12. When, e.g., the p-type semiconductor film 12 is formed of $Cu_2O$, a wet etching method using an acidic solution such as a buffered hydrofluoric acid solution, dilute hydrofluoric acid, diluted aqua regia, or dilute sulfuric acid, or a dry etching method can be used to etch the p-type semiconductor film 12, and the above wet etching method and the dry etching method can be used in combination.

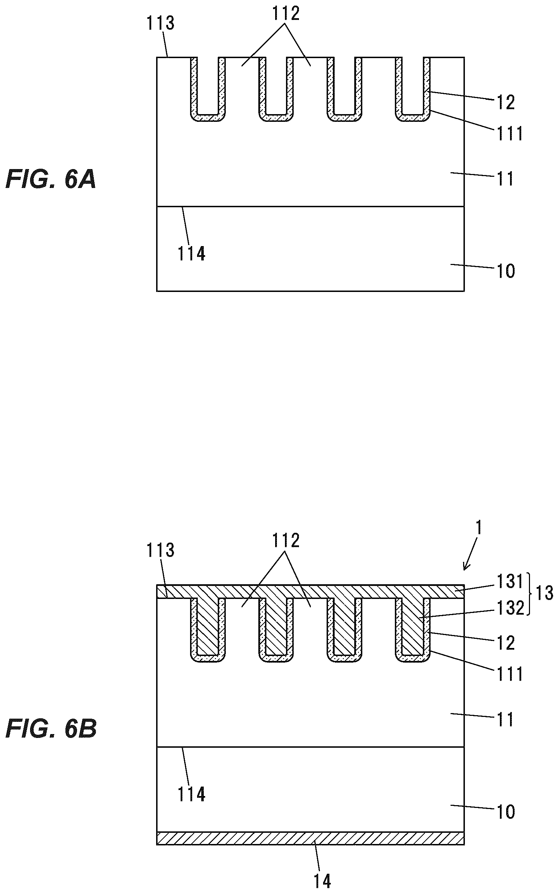

Next, as shown in FIG. 6A, the photoresist 20 is removed. For example, an organic chemical agent such as NMP or acetone is used to remove the photoresist 20.

Next, as shown in FIG. 6B, the anode electrode 13 is formed on the first surface 113 of the n-type semiconductor layer 11 so that the portion 132 thereof is covered with the p-type semiconductor films 12 in the plural trenches 111, and the cathode electrode 14 is formed on the bottom surface of the n-type semiconductor substrate 10. For example, an electron beam evaporation method is used to form the anode electrode 13 and the cathode electrode 14.

The p-type semiconductor film 12 is film that covers the inner surface of the trench 111. Therefore, as compared to when filling the trenches 111 with a p-type semiconductor, time required to deposit the material is shorter and the time required to remove the portion formed outside the trenches 111 is also shorter.

In addition, the portion of the p-type semiconductor film 12 formed outside the trenches 111 is removed by the resist etch-back method using the photoresist 20 in the method described above but may be removed by polishing process such as CMP.

(Modifications)

The n-type semiconductor layer 11 may be formed of a material other than the gallium oxide-based semiconductor. Also in this case, electron affinity $\chi_n$ and work function $\varphi_n$ of the material of the n-type semiconductor layer 11 and electron affinity $\chi_p$ and work function $\varphi_p$ of the material of the p-type semiconductor film 12 satisfy the condition represented by Expression 1 above.

As described above, the p-type semiconductor film 12 is a deposited film and is not formed as part of the n-type semiconductor layer 11 by ion implantation. Therefore, even when the n-type semiconductor layer 11 is formed of a material that is difficult to convert into p-type, such as a gallium oxide-based semiconductor, the p-type semiconductor film 12 can be formed using a material (base material) different from the n-type semiconductor layer 11.

When the breakdown field strength of the n-type semiconductor layer 11 is large, it is possible to have a large withstand voltage while suppressing an increase in on-resistance. For this reason, the n-type semiconductor layer 11 is preferably formed of, e.g., a material with a breakdown field strength of not less than 1 MV/cm or a band gap energy of not less than 1.

In addition to the gallium oxide-based semiconductor, e.g., SiC with a breakdown field strength of 2.5 MV/cm and a band gap energy of 3.3 eV, GaN with a breakdown field strength of 3.3 MV/cm and a band gap energy of 3.4 eV, $Al_xIn_yGa_{1-x-y}N$ with a breakdown field strength of 1.2 to 12 MV/cm and a band gap energy of 0.6 to 6.2 eV, or diamond with a breakdown field strength of about 8.0 MV/cm and a band gap energy of 5.5 eV can be used as the material of the n-type semiconductor layer 11.

The n-type semiconductor substrate 10 may also be formed of a material other than the gallium oxide-based semiconductor. The same material as the n-type semiconductor layer 11 can be used as the material of the n-type semiconductor substrate 10.

(Effects of the embodiment)

According to the embodiment described above, it is possible to provide the JBS diode 1 with a trench structure that is excellent in surge resistance and exhibits suppressed energy losses during switching operations, and a method for manufacturing the same. The JBS diode 1 has high surge resistance and low turn-on voltage and can thus be suitably used in, e.g., a power converter circuit such as AC-DC converter.

Although the embodiment of the invention has been described, the invention is not intended to be limited to the embodiment, and the various kinds of modifications can be implemented without departing from the gist of the invention. In addition, the invention according to claims is not to be limited to the embodiment described above. Further, it should be noted that not all combinations of the features described in the embodiment are necessary to solve the problem of the invention.

Industrial Applicability

Provided are a junction barrier Schottky diode with a trench structure that is excellent in surge resistance and exhibits suppressed energy losses during switching operations, and a method for manufacturing the same.

Reference Signs List

| | |
|---|---|
| 1 | JUNCTION BARRIER SCHOTTKY DIODE |
| 10 | N-TYPE SEMICONDUCTOR SUBSTRATE |
| 11 | N-TYPE SEMICONDUCTOR LAYER |
| 111 | TRENCH |
| 112 | MESA-SHAPED PORTION |
| 113 | FIRST SURFACE |
| 114 | SECOND SURFACE |
| 12 | P-TYPE SEMICONDUCTOR FILM |
| 13 | ANODE ELECTRODE |
| 14 | CATHODE ELECTRODE |

**Claims**

1. A junction barrier Schottky diode, comprising:

   an n-type semiconductor layer comprising an n-type semiconductor and having a plurality of trenches that open on a first surface;
   a p-type semiconductor film comprising a p-type semiconductor and provided in contact with inner surfaces of the plurality of trenches;
   an anode electrode that is provided on the first surface of the n-type semiconductor layer so as to be in contact with a mesa-shaped portion between the plurality of trenches of the n-type semiconductor layer and comprises a portion covered with the p-type semiconductor film in the plurality of trenches; and
   a cathode electrode provided, directly or through another layer, on a second surface of the n-type semiconductor layer opposite to the first surface,
wherein electron affinity $\chi_p$ and work function $\varphi_p$ of the p-type semiconductor and electron affinity $\chi_n$ and work function $\varphi_n$ of the n-type semiconductor satisfy a condition represented by an expression of the form $\chi_n - \chi_p > \varphi_p - \varphi_n$.

2. The junction barrier Schottky diode according to claim 1, wherein the n-type semiconductor layer and the p-type semiconductor film comprise different semiconductors.

3. The junction barrier Schottky diode according to claim 2, wherein the n-type semiconductor layer comprises a gallium oxide-based semiconductor.

4. The junction barrier Schottky diode according to any one of claims 1 to 3, wherein the p-type semiconductor includes $Cu_2O$, NiO, $Ag_2O$, polycrystalline Si, single crystal Si, amorphous Si, SnO, or CuO.

5. A method for manufacturing a junction barrier Schottky diode, comprising:

   forming a plurality of trenches on a first surface of an n-type semiconductor layer that comprises an n-type semiconductor;
   forming a p-type semiconductor film that comprises a p-type semiconductor and is in contact with inner surfaces of the plurality of trenches;
   forming, on the first surface of the n-type semiconductor layer, an anode electrode that comprises a portion covered with the p-type semiconductor film in the plurality of trenches; and
   forming a cathode electrode, directly or through another layer, on a second surface of the n-type semiconductor layer opposite to the first surface,
   wherein electron affinity $\chi_p$ and work function $\varphi_p$ of the p-type semiconductor and electron affinity $\chi_n$ and work function $\varphi_n$ of the n-type semiconductor satisfy a condition represented by an expression of the form $\chi_n - \chi_p > \varphi_p - \varphi_n$.

## FIG. 1

*FIG. 2A*

*FIG. 2B*

*FIG. 3A*

*FIG. 3B*

*FIG. 4A*

113

11

114

10

*FIG. 4B*

113

112

111

11

114

10

*FIG. 4C*

113

112

12

111

11

114

10

*FIG. 5A*

*FIG. 5B*

*FIG. 5C*

*FIG. 6A*

*FIG. 6B*

| INTERNATIONAL SEARCH REPORT | International application No. |
|---|---|
| | **PCT/JP2022/046558** |

**A.    CLASSIFICATION OF SUBJECT MATTER**

*H01L 29/872*(2006.01)i; *H01L 21/329*(2006.01)i; *H01L 29/47*(2006.01)i; *H01L 29/861*(2006.01)i; *H01L 29/868*(2006.01)i
FI:    H01L29/86 301F; H01L29/91 K; H01L29/86 301D; H01L29/91 F; H01L29/86 301M; H01L29/91 D; H01L29/86 301P; H01L29/48 D; H01L29/48 F

According to International Patent Classification (IPC) or to both national classification and IPC

**B.    FIELDS SEARCHED**

Minimum documentation searched (classification system followed by classification symbols)

H01L29/872; H01L21/329; H01L29/47; H01L29/861; H01L29/868

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| Y | WO 2019/155768 A1 (MITSUBISHI ELECTRIC CORP.) 15 August 2019 (2019-08-15) paragraphs [0016]-[0116], fig. 1-5 | 1-5 |
| Y | JP 2021-103747 A (NOVEL CRYSTAL TECHNOLOGY INC.) 15 July 2021 (2021-07-15) paragraphs [0048], [0057], [0060], fig. 4, 5 | 1-5 |
| Y | JP 2009-130013 A (NIPPON LIGHT METAL CO., LTD., KYOTO UNIV.) 11 June 2009 (2009-06-11) paragraphs [0010], [0029], fig. 4 | 1-5 |
| Y | JP 2013-222858 A (UNIV. OF ELECTRO-COMMUNICATIONS, NIPPON DENGYO KOSAKU CO., LTD.) 28 October 2013 (2013-10-28) paragraphs [0023]-[0049], fig. 1-3 | 1-5 |
| Y | JP 2012-234949 A (PANASONIC CORP.) 29 November 2012 (2012-11-29) paragraphs [0040], [0044], fig. 2 | 1-5 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 March 2023** | **14 March 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/046558**

| Patent document cited in search report | | | Publication date (day/month/year) | Patent family member(s) | | | Publication date (day/month/year) |
|---|---|---|---|---|---|---|---|
| WO | 2019/155768 | A1 | 15 August 2019 | US 2021/0074826 A1 paragraphs [0028]-[0128], fig. 1-5 CN 111656532 A | | | |
| JP | 2021-103747 | A | 15 July 2021 | US 2023/043402 A1 paragraphs [0067], [0076], [0079], fig. 4, 5 WO 2021/131893 A1 CN 114846590 A | | | |
| JP | 2009-130013 | A | 11 June 2009 | CN 101868862 A paragraphs [0045], [0072], fig. 4 KR 10-2010-0087017 A | | | |
| JP | 2013-222858 | A | 28 October 2013 | (Family: none) | | | |
| JP | 2012-234949 | A | 29 November 2012 | (Family: none) | | | |

Form PCT/ISA/210 (patent family annex) (January 2015)

## REFERENCES CITED IN THE DESCRIPTION

**Patent documents cited in the description**

- JP 2019036593 A